# EUROPÄISCHE PATENTSCHRIFT

(11) **EP 2 537 163 B1**
(45) Veröffentlichungstag und Bekanntmachung des Hinweises auf die Patenterteilung: **10.12.2014**
(21) Anmeldenummer: 11703173.2
(22) Anmeldetag: 01.02.2011
(51) Int. Cl.: H01L 49/02, H01C 7/112, H01C 7/12

(54) **ELEKTRISCHES WIDERSTANDSELEMENT GEIGNET FÜR LEUCHTDIODEN, LASERDIODEN ODER FOTODETEKTOREN**
ELECTRIC RESISTIVE ELEMENT ADAPTED FOR LIGHTDIODES, LASERDIODES OR FOTODETECTORS
ELEMENT RESISTIF ELECTRIQUE ADAPTE POUR LES DIODES ELECTRO-LUMINESCENTES, LES DIODES LASER OU LES PHOTODETECTEURS

(30) Priorität: 19.02.2010 DE 102010008603
(43) Veröffentlichungstag der Anmeldung: 26.12.2012
(73) Patentinhaber: OSRAM Opto Semiconductors GmbH, 93055 Regensburg (DE)
(72) Erfinder: BERGENEK, Krister, 93059 Regensburg (DE)
(74) Vertreter: Epping - Hermann - Fischer
(86) Internationale Anmeldenummer: PCT/EP2011/051388
(87) Internationale Veröffentlichungsnummer: WO 2011/101238

(56) Entgegenhaltungen:
- GB-A- 2 095 474
- US-A1- 2006 001 046
- US-A1- 2008 083 929
- US-B1- 6 236 668

## Beschreibung

Es wird ein elektrisches Widerstandselement angegeben.

Eine zu lösende Aufgabe besteht darin, ein elektrisches Widerstandselement anzugeben, dass sich besonders gut für die Verwendung mit optoelektronischen Bauelementen wie beispielsweise Leuchtdioden, Laserdioden oder Fotodetektoren eignet.

Dokument GB-A-2095474 offenbart ein Leuchtdiode mit einen Grundkörper der aus Halbleitermaterial gebildet ist. Ein erstes Kontaktelement ist gebildet damit der Grundkörper elektrisch leitend verbunden ist. Ein zweites Kontaktelement ist anderseits mit dem Grundkörper leitend verbunden. Auf der ersten Oberfläche des Grundkörpers ist eine Ausnehmung über ein "Kanal" eingebracht. Der "Kanal" ist mit einem "leichten" Widerstandsmaterial als die Seiten des Grundkörpers gebaut.

Gemäß zumindest einer Ausführungsform des elektrischen Widerstandselement umfasst das elektrische Widerstandselement einen Grundkörper. Der Grundkörper ist beispielsweise mit einem Halbleitermaterial gebildet. Das heißt, der Grundkörper kann aus einem Halbleitermaterial bestehen, in das beispielsweise Dotierstoffe eingebracht sind. Zum Beispiel besteht der Grundkörper aus einem n- oder einem p-dotierten Silizium. Es ist jedoch auch möglich, dass der Grundkörper eine Schichtstruktur aufweist, in der beispielsweise Halbleitermaterialien und Metalle schichtartig übereinander angeordnet sind.

Gemäß zumindest einer Ausführungsform des elektrischen Widerstandselements umfasst das Widerstandselement ein erstes Kontaktelement. Das erste Kontaktelement ist mit dem Grundkörper elektrisch leitend verbunden. Das Kontaktelement besteht aus einem elektrisch leitenden Material, beispielsweise aus einem Metall. Beispielsweise ist das erste Kontaktelement als Schicht ausgebildet, die stellenweise auf den Grundkörper aufgebracht ist und Konturen des Grundkörpers folgt. Die Schicht kann sich dann in direktem Kontakt mit dem Grundkörper befinden.

Gemäß zumindest einer Ausführungsform des elektrischen Widerstandselements umfasst das Widerstandselement ein zweites Kontaktelement, das mit dem Grundkörper elektrisch leitend verbunden ist. Das zweite Kontaktelement kann ebenfalls aus einem elektrisch leitenden Material wie beispielsweise einem Metall bestehen. Das zweite Kontaktelement kann als Schicht ausgebildet sein, die formschlüssig stellenweise auf dem Grundkörper aufgebracht ist.

Das erste und das zweite Kontaktelement sind dabei nicht direkt elektrisch leitend miteinander verbunden, sondern wenigstens der Grundkörper des elektrischen Widerstandselements ist zwischen dem ersten und dem zweiten Kontaktelement angeordnet. Das heißt, ein Strom zwischen dem ersten und dem zweiten Kontaktelement fließt durch den Grundkörper oder durch zumindest Teile des Grundkörpers.

Gemäß zumindest einer Ausführungsform des elektrischen Widerstandselements weist der Grundkörper eine erste Hauptfläche auf, in die eine Ausnehmung eingebracht ist. Das heißt, an einer ersten Hauptfläche des Grundkörpers - zum Beispiel an einer Oberseite des Grundkörpers - ist Material des Grundkörpers entnommen, so dass der Grundkörper dort ein Loch oder eine Öffnung aufweist. Die Ausnehmung ist dabei vorzugsweise nicht derart ausgebildet, dass sie von einer Seite des Grundkörpers zu einer gegenüberliegenden Seite des Grundkörpers reicht, sondern es ist durch die Ausnehmung lediglich eine Öffnung oder ein Loch im Grundkörper gebildet, welches den Grundkörper nicht vollständig durchdringt.

Gemäß zumindest einer Ausführungsform des elektrischen Widerstandselements ist das erste Kontaktelement in der Ausnehmung zumindest stellenweise elektrisch leitend mit dem Grundkörper verbunden. Beispielsweise können im Bereich der Ausnehmung wenigstens 85 % des Grundkörpers vom Kontaktelement bedeckt sein. Dabei ist es möglich, dass der Grundkörper im Bereich der Ausnehmung vollständig vom Kontaktelement bedeckt ist. Das Kontaktelement kann sich dann in der Ausnehmung in direktem Kontakt mit dem Grundkörper befinden. Beispielsweise ist der Grundkörper im Bereich der Ausnehmung mit dem Material des ersten Kontaktelements beschichtet.

Gemäß zumindest einer Ausführungsform des elektrischen Widerstandselements weist der Grundkörper des Widerstandselements eine zweite Hauptfläche auf. Die zweite Hauptfläche ist beispielsweise zur ersten Hauptfläche gegenüberliegend angeordnet. Der Grundkörper des elektrischen Widerstandselements kann beispielsweise nach Art eines Zylinders oder eines Quaders ausgebildet sein. Die Hauptflächen des Grundkörpers sind dann beispielsweise durch die Deckflächen des Zylinders beziehungsweise des Quaders gebildet.

Gemäß zumindest einer Ausführungsform des elektrischen Widerstandselements ist das zweite Kontaktelement an der zweiten Hauptfläche zumindest stellenweise elektrisch leitend mit dem Grundkörper verbunden. Beispielsweise bedeckt das zweite Kontaktelement dazu die zweite Hauptfläche stellenweise oder vollständig. Das zweite Kontaktelement kann beispielsweise als Metallschicht auf die zweite Hauptfläche des Grundkörpers aufgebracht sein. Es ist insbesondere möglich, dass sich das zweite Kontaktelement und der Grundkörper in direktem Kontakt miteinander befinden.

Gemäß zumindest einer Ausführungsform des elektrischen Widerstandselements umfasst das elektrische Widerstandselement einen Grundkörper, der mit einem Halbleitermaterial gebildet ist. Weiter umfasst das Widerstandselement ein erstes und ein zweites Kontaktelement, die jeweils mit dem Grundkörper elektrisch leitend verbunden sind. Dabei weist der Grundkörper eine erste Hauptfläche auf, in die eine Ausnehmung eingebracht ist. Das erste Kontaktelement in der Ausnehmung ist zumindest stellenweise elektrisch leitend mit dem Grundkörper verbunden. Der Grundkörper weist weiter eine zweite Hauptfläche auf, die der ersten Hauptfläche gegenüberliegend angeordnet ist. Das zweite Kontaktelement ist an der zweite Hauptfläche zumindest stellenweise elektrisch leitend mit dem Grundkörper verbunden.

Im Betrieb des elektrischen Widerstandselements durchfließt ein elektrischer Strom ausgehend beispielsweise vom ersten Kontaktelement den Grundkörper und gelangt von dort in das zweite Kontaktelement. Die Ausnehmung im Grundkörper erstreckt sich dabei beispielsweise von der ersten Hauptfläche in Richtung der zweiten Hauptfläche. Aufgrund der Tatsache, dass das erste Kontaktelement in die Ausnehmung eingebracht ist und dort elektrisch leitend mit dem Grundkörper verbunden ist, verringert sich durch die Ausnehmung die Kurzschlussstrecke durch den Grundkörper hindurch zwischen dem ersten Kontaktelement und dem zweiten Kontaktelement. Auf diese Weise ist es möglich, einen relativ dicken, mechanisch stabilen Grundkörper zu wählen, bei dem die Kurzschlussstrecke durch den Grundkörper hindurch durch die Ausnehmung derart verringert ist, dass der Widerstand des Widerstandselements trotz der Verwendung eines dicken Grundkörpers nicht zu groß wird, um beispielsweise für optoelektronische Halbleiterbauelemente wie Leuchtdioden verwendet zu werden. Über die Tiefe der Ausnehmung, das heißt den Abstand zwischen erstem Kontaktelement und zweitem Kontaktelement beziehungsweise der Länge der daraus resultierenden Kurzschlussstrecke durch den Grundkörper hindurch, kann der Widerstand des elektrischen Widerstandselements auf einfache Weise eingestellt werden, so dass beispielsweise eine Anpassung des Widerstands an die Vorwärtsspannung und die Helligkeit eines Leuchtdiodenchips erfolgen kann, mit dem das elektrische Widerstandselement Verwendung findet.

Gemäß zumindest einer Ausführungsform des elektrischen Widerstandselements ist zwischen der ersten Hauptfläche und dem ersten Kontaktelement ein elektrisch isolierendes Passivierungselement angeordnet. Das heißt, zumindest stellenweise befindet sich das erste Kontaktelement nicht in direktem Kontakt mit der ersten Hauptfläche des Grundkörpers, sondern zwischen Bereichen des ersten Kontaktelements und der ersten Hauptfläche des Grundkörpers ist ein elektrisch isolierendes Passivierungselement angeordnet. Bei dem elektrisch isolierenden Passivierungselement handelt es sich beispielsweise um eine elektrisch isolierende Schicht, die aus einem keramischen Material, aus Siliziumnitrid oder aus Siliziumdioxid gebildet sein kann.

Gemäß zumindest einer Ausführungsform des elektrischen Widerstandselements sind das erste Kontaktelement und der Grundkörper lediglich im Bereich der Ausnehmung des Grundkörpers elektrisch leitend miteinander verbunden. Das heißt, nur im Bereich der Ausnehmung besteht ein elektrisch leitender Kontakt zwischen dem ersten Kontaktelement und dem Grundkörper. Dies kann dadurch erreicht sein, dass das erste Kontaktelement lediglich im Bereich der Ausnehmung auf den Grundkörper aufgebracht ist, oder dass Teile des Grundkörpers mittels eines elektrisch isolierenden Passivierungselements elektrisch isoliert vom Kontaktelement sind. Beispielsweise umgibt das Passivierungselement die Ausnehmung an der ersten Hauptfläche des Grundkörpers und das erste Kontaktelement ist zumindest stellenweise direkt auf das Passivierungselement und auf den Grundkörper im Bereich der Ausnehmung aufgebracht.

Gemäß zumindest einer Ausführungsform des elektrischen Widerstandselements weist die Ausnehmung im Grundkörper zumindest eine Seitenfläche und zumindest eine Bodenfläche auf, wobei die zumindest eine Seitenfläche und die zumindest eine Bodenfläche die Ausnehmung zum Grundkörper hin begrenzen. Nach oben hin, das heißt in Richtung der ersten Hauptfläche des Grundkörpers ist in die Ausnehmung beispielsweise das erste Kontaktelement eingebracht. Die zumindest eine Seitenfläche und die zumindest eine Bodenfläche können dann vollständig in direktem Kontakt mit dem ersten Kontaktelement stehen. Mit anderen Worten kann der in der Ausnehmung freiliegende Grundkörper in der Ausnehmung vollständig vom ersten Kontaktelement bedeckt sein.

Gemäß zumindest einer Ausführungsform des elektrischen Widerstandselements ist die Ausnehmung nach Art einer Pyramide ausgebildet, deren Spitze der zweiten Hauptfläche zugewandt ist. Das heißt, die Pyramide verjüngt sich von der ersten Hauptfläche aus gesehen in Richtung der zweiten Hauptfläche. Im Querschnitt kann die Ausnehmung dann beispielsweise eine dreieckige Form aufweisen, wobei die Spitze des Dreiecks der zweiten Hauptfläche des Grundkörpers zugewandt ist.

Gemäß zumindest einer Ausführungsform des elektrischen Widerstandselements weist die Ausnehmung an ihrer zumindest einen Seitenfläche und ihrer zumindest einen Bodenfläche Spuren eines Ätzprozesses auf. Mit anderen Worten ist die Ausnehmung dann durch einen Ätzprozess erzeugt. Beispielsweise kann die Ausnehmung durch einen nasschemischen anisotropen Ätzprozess zum Beispiel mit KOH erzeugt sein. Ist der Grundkörper beispielsweise mit Silizium gebildet und liegt eine (100)-Oberfläche an der ersten Hauptfläche frei, so wird mittels eines nasschemischen anisotropen Ätzvorgangs eine pyramidenartige Ausnehmung im Grundkörper erzeugt. Der halbe Öffnungswinkel der Pyramide beträgt dann idealerweise 35,3°. Aufgrund des anisotropen Ätzens endet der Ätzvorgang, sobald sich die Pyramide oder die pyramidenartige Ausnehmung ausgebildet hat.

Gemäß zumindest einer Ausführungsform des Widerstandselements weist das Widerstandselement einen positiven Temperaturkoeffizienten auf. Das bedeutet, mit steigender Temperatur des Widerstandselements steigt auch dessen elektrischer Widerstand an.

Gemäß zumindest einer Ausführungsform des elektrischen Widerstandselements besteht der Grundkörper aus einem dotierten Silizium, das n- oder p-dotiert ist. Die Dotierstoffkonzentration beträgt dabei vorzugsweise wenigstens 10¹⁵ cm⁻³ und höchsten 10¹⁶ cm⁻³. Eine relativ niedrige Dotierstoffkonzentration ist dabei erwünscht, um einen hohen positiven Temperaturkoeffizienten zu erreichen. Vorzugsweise steigt der Widerstand des elektrischen Widerstandselements in einem Temperaturbereich zwischen 25° C und 150° C um einen Faktor von wenigstens 2, vorzugsweise von wenigstens 3 an. So beträgt dieser Faktor für einen Grundkörper aus Silizium für eine p-Dotierstoffkonzentration von 10¹⁵/cm³ zirka 3,3, für eine Dotierstoffkonzentration von 10¹⁶/cm³ zirka 2,9 und für eine Dotierstoffkonzentration von 10¹⁷/cm³ zirka 2,2. Für eine Dotierstoffkonzentration von 10¹⁸/cm³ betrüge der Faktor nur noch 1,8, was für die Verwendung beispielsweise mit Leuchtdiodenchips zu gering ist.

Gemäß zumindest einer Ausführungsform des elektrischen Widerstandselements weist der Grundkörper eine Dicke von wenigstens 100 µm auf. Die Dicke ist dabei der Abstand zwischen der ersten Hauptfläche ohne die Ausnehmung und der zweiten Hauptfläche. Solch dicke Grundkörper bei niedriger Dotierstoffkonzentration sind vorliegend durch die Ausnehmung ermöglicht, die die Kurzschlussstrecke zwischen dem ersten Kontaktelement und dem zweiten Kontaktelement soweit verringert, dass der Widerstand des elektrischen Widerstandselements in einem Bereich von höchstens 10 Ω liegt, was beispielsweise zur Verwendung mit optoelektronischen Halbleiterbauelementen gewünscht ist. Zum Beispiel beträgt der Widerstand wenigstens 3 Ω.

Die Grundfläche der ersten Hauptfläche und/oder der zweiten Hauptfläche kann dabei beispielsweise höchstens 1 mm² betragen.

Es wird darüber hinaus ein Verfahren zur Herstellung einer Vielzahl elektrischer Widerstandselemente angegeben. Mit dem Verfahren sind hier beschriebene elektrische Widerstandselemente herstellbar. Das heißt, die für das Widerstandselement offenbarten Merkmale sind auch für das Verfahren offenbart und umgekehrt.

Das Verfahren umfasst dabei die folgenden Schritte: Zunächst wird ein Wafer bereitgestellt, der aus einem Halbleitermaterial besteht. Das Halbleitermaterial des Wafers bildet im späteren Widerstandselement den Grundkörper.

Anschließend wird ein Passivierungselement auf eine erste Hauptfläche des Wafers aufgebracht. Die erste Hauptfläche des Wafers entspricht später im Widerstandselement der ersten Hauptfläche des Grundkörpers. Das Passivierungselement wird beispielsweise als Schicht aus einem elektrisch isolierenden Material wie Siliziumdioxid oder Siliziumnitrid aufgebracht. Im Passivierungselement werden stellenweise Öffnungen gebildet, in denen das Halbleitermaterial freiliegt. Dies kann entweder durch eine Maskentechnik geschehen, so dass das Halbleitermaterial des Wafers im Bereich der Öffnungen nicht vom Passivierungselement bedeckt wird oder das Passivierungselement wird nachträglich entfernt.

Nachfolgend wird ein nasschemisches Ätzverfahren - beispielsweise mit KOH - auf das in den Öffnungen freigelegte Halbleitermaterial zur Bildung von Ausnehmungen durchgeführt. Liegt beispielsweise eine Silizium (100)-Oberfläche in den Öffnungen frei, so bildet sich durch eine anisotropes nasschemisches Ätzverfahren eine pyramidenartige Ausnehmung aus, deren Spitze von der ersten Hauptfläche des Wafers weggerichtet ist. Die Höhe der Pyramide und damit die Länge der Kurzschlussstrecke im späteren Widerstandselement ist durch die Dicke des Wafers, also die Dicke des späteren Grundkörpers, und den Durchmesser der Öffnung im Passivierungselement, das heißt den maximalen Durchmesser der späteren Ausnehmung, bestimmt. Bei einem vorgegebenen Wafer gleichmäßiger Dicke kann also allein über Größe und Form der Öffnung der Widerstand des herzustellenden Widerstandselements eingestellt werden. Insbesondere ist es möglich, auf einem Wafer Widerstandselemente mit unterschiedlichem elektrischen Widerstand herzustellen, in dem unterschiedlich große Öffnungen im Passivierungselement gewählt werden.

In einem weiteren Verfahrensschritt kann jeweils ein erstes Kontaktelement in die durch den Ätzprozess gebildeten Ausnehmungen eingebracht werden.

Gemäß zumindest einer Ausführungsform des Verfahrens können dabei zumindest zwei Ausnehmungen in dem Wafer einen voneinander unterschiedlichen maximalen Durchmesser aufweisen. Das heißt, die zugehörigen Widerstandselemente weisen dann einen unterschiedlichen elektrischen Widerstand auf.

In einem weiteren Verfahrensschritt kann der Wafer mit dem in den Wafern erzeugten Ausnehmungen in einzelne Widerstandselemente zerteilt werden. Das Aufbringen eines zweiten Kontaktelements kann dabei vor oder nach dem Vereinzeln erfolgen.

Es wird weiter eine Beleuchtungsvorrichtung angegeben. Die Beleuchtungsvorrichtung enthält beispielsweise eine Mehrzahl von Leuchtdiodenchips, die im Betrieb elektromagnetische Strahlung erzeugen.

Gemäß zumindest einer Ausführungsform der Beleuchtungsvorrichtung umfasst die Beleuchtungsvorrichtung eine erste Anordnung von Leuchtdioden, die zumindest eine Leuchtdiode erster Art umfasst. Beispielsweise umfasst die erste Anordnung einen oder mehrere rotes Licht emittierende Leuchtdiodenchips.

Die Beleuchtungsvorrichtung umfasst ferner eine zweite Anordnung von Leuchtdioden, die zumindest eine Leuchtdiode zweiter Art umfasst. Beispielsweise umfasst die zweite Anordnung einen oder mehrere Leuchtdiodenchips, die im Betrieb grünes oder blaues Licht emittieren. Die Leuchtdioden erster Art und die Leuchtdioden zweiter Art unterscheiden sich dabei hinsichtlich ihrer Temperaturabhängigkeit. Die Leuchtdioden erster Art erzeugen elektromagnetische Strahlung bei steigenden Temperaturen mit geringerer Effizienz als die Leuchtdioden zweiter Art. Mit anderen Worten sind die Leuchtdioden erster Art temperaturempfindlicher als die Leuchtdioden zweiter Art, die Intensität das von den Leuchtdioden erster Art abgestrahlten Lichts nimmt mit steigenden Temperaturen stärker ab als bei den Leuchtdioden zweiter Art.

Die Beleuchtungsvorrichtung umfasst ferner ein hier beschriebenes Widerstandselement. Die zweite Anordnung von Leuchtdioden und das Widerstandselement bilden dabei eine Serienschaltung und die Serienschaltung bildet mit der ersten Anordnung von Leuchtdioden eine Parallelschaltung.

Das heißt, die temperaturunempfindlicheren Leuchtdioden sind mit dem Widerstandselement in einer Serienschaltung zusammengefasst, welcher die temperaturempfindlicheren Leuchtdioden parallel geschaltet sind. Mit einer solchen Beleuchtungsvorrichtung kann Mischlicht des von der ersten Anordnung von Leuchtdioden und der zweiten Anordnung von Leuchtdioden abgestrahlten Mischlichts mit besonders hoher Farbhomogenität erzeugt werden. Im Betrieb der Beleuchtungsvorrichtung steigt mit höheren Temperaturen der Widerstand des Widerstandselements an, so dass mehr Spannung am Widerstandselement und weniger Spannung an den Leuchtdioden zweiter Art abfällt. Der Widerstand sowie der positive Temperaturkoeffizient des Widerstandselements werden dabei derart abgestimmt, dass die resultierende Abnahme der Strahlungsleistung der Leuchtdioden zweiter Art aufgrund des Leistungsabfalls am Widerstandselement mit der reduzierten Strahlleistung der Leuchtdioden erster Art, die aufgrund ihrer erhöhten Temperaturempfindlichkeit elektromagnetische Strahlung verringerter Intensität emittieren, korrespondiert.

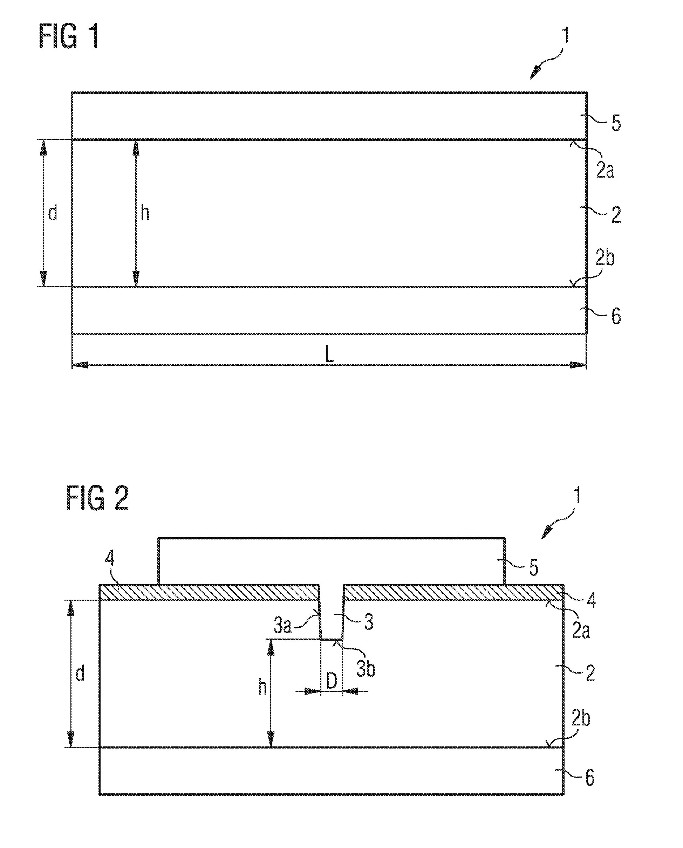

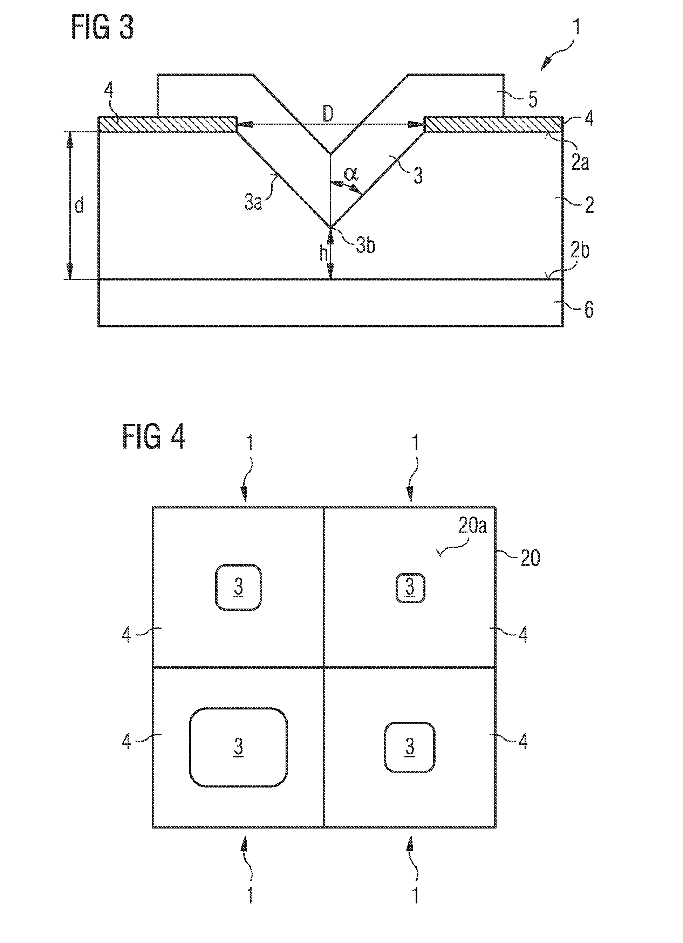

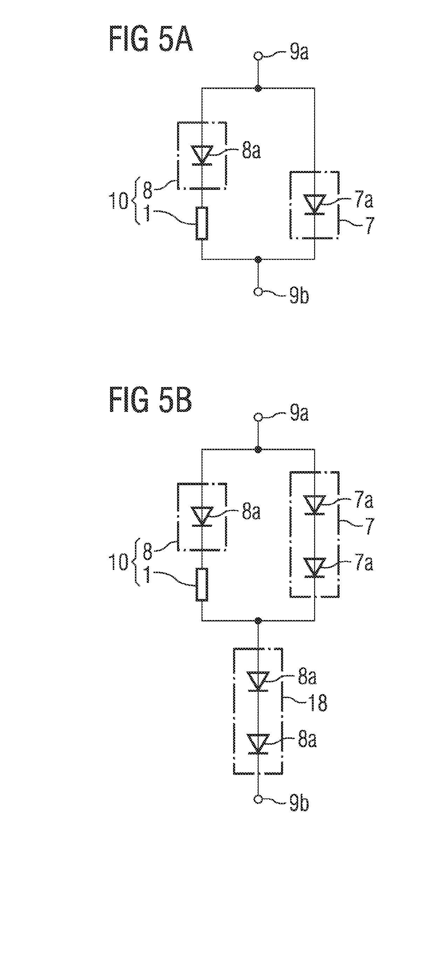

Im Folgenden werden hier beschriebene elektrische Widerstandselemente, hier beschriebene Verfahren und hier beschriebene Beleuchtungsvorrichtungen anhand von Ausführungsbeispielen und den dazugehörigen Figuren näher erläutert.
- Anhand: der schematischen Schnittdarstellung der Figur 1 wird ein einem hier beschriebenen elektrischen Widerstandselement zugrunde liegendes Problem näher erläutert.
- Anhand: der schematischen Schnittdarstellung der Figur 2 ist ein erstes Ausführungsbeispiel eines hier beschriebenen elektrischen Widerstandselements näher erläutert.
- Anhand: der schematischen Schnittdarstellung der Figur 3 ist ein zweites Ausführungsbeispiel eines hier beschriebenen elektrischen Widerstandselements näher erläutert.
- Anhand: der schematischen Draufsicht der Figur 4 ist ein hier beschriebenes Verfahren näher erläutert.
- Anhand: der schematischen Schaltskizzen der Figuren 5A und 5B sind Ausführungsbeispiele von hier beschriebenen Beleuchtungsvorrichtungen näher erläutert.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

Die Figur 1 zeigt ein herkömmliches Widerstandselement 1 in einer schematischen Schnittdarstellung. Das Widerstandselement 1 umfasst einen Grundkörper 2, der mit dotiertem Silizium gebildet ist. Der Grundkörper 2 weist einen positiven Temperaturkoeffizienten des Widerstands auf, das heißt mit steigender Temperatur steigt auch der Widerstand des Grundkörpers 2. Der Grundkörper 2 weist beispielsweise die Form eines Quaders oder eines Zylinders auf. Auf die erste Hauptfläche 2a des Grundkörpers 2 ist ein erstes Kontaktelement 5 aufgebracht. Auf die der ersten Hauptfläche 2a gegenüberliegende zweite Hauptfläche 2b des Grundkörpers ist ein zweites Kontaktelement 6 aufgebracht.

Die Kontaktelemente 5, 6 bestehen aus einem elektrisch leitenden Material, wie beispielsweise aus einem Metall. Beispielsweise enthalten die Kontaktelemente 5, 6 Gold und/oder Platin. Ferner ist es möglich, dass die Kontaktelemente 5, 6 aus Aluminium bestehen oder Aluminium enthalten. Ferner kann es sich bei den Kontaktelementen 5, 6 um Mehrschichtmetallisierungen handeln mit zum Beispiel folgenden Schichtabfolgen: Al/TiWN/Ti/Pt/Au oder Al/Ti/Pt/Au.

Die Kurzschlussstrecke durch den Grundkörper 2 hindurch zwischen dem ersten Kontaktelement 5 und dem zweiten Kontaktelement 6 weist die Länge h auf, die vorliegend durch die Dicke d des Grundkörpers 2 bestimmt ist. Damit der Grundkörper 2 mechanisch ausreichend stabil ist, sollte er eine Dicke von wenigstens 100 µm, beispielsweise zwischen 100 µm und 500 µm aufweisen, zum Beispiel zwischen 100 µm und 200 µm. Die daraus resultierende Kurzschlussstrecke h ist so groß, dass - um den Widerstand des Widerstandselements in einem Bereich zwischen 3 und 10 Ω zu halten - die Dotierung des Grundkörpers 2 sehr hoch, beispielsweise größer als 10¹⁹/cm³ gewählt werden muss. Dies führt jedoch dazu, dass der Anstieg des Widerstands mit der Temperatur zu gering wird, um beispielsweise bei der Verwendung von blauen Leuchtdioden den Leistungsabfall im Vergleich zu roten Leuchtdioden auszugleichen. Ferner kann der Widerstandswert des Widerstandselements 1 gemäß der Figur 1 nur durch eine Verringerung der Dicke des Grundkörpers bei gleich bleibenden Temperaturkoeffizienten eingestellt werden, so dass mit einem Wafer keine unterschiedlichen Widerstandselemente erzeugt werden können. Folglich ist eine Anpassung des Widerstands an die Einsatzerfordernisse nur schlecht möglich.

Anhand der Figur 2 ist ein erstes Ausführungsbeispiel eines hier beschriebenen Widerstandselements näher erläutert. Im Unterschied zum Widerstandselement der Figur 1 wird beim Widerstandselement der Figur 2 der elektrische Strom nicht ganzflächig über das erste Kontaktelement 5 in den Grundkörper 2 eingeprägt, sondern zwischen dem Grundkörper 2 und dem ersten Kontaktelement 5 befindet sich ein Passivierungselement 4. Bei dem Passivierungselement 4 handelt es sich beispielsweise um eine elektrisch isolierende Schicht aus Siliziumdioxid oder Siliziumnitrid, in welche eine Öffnung eingebracht ist. Unterhalb der Öffnung befindet sich eine Ausnehmung 3, in der Material des Grundkörpers 2 entfernt ist. Vorliegend handelt es sich bei der Ausnehmung 3 beispielsweise um eine Bohrung, die mechanisch oder mittels Laserstrahlung in den Grundkörper 2 eingebracht ist. Im Bereich der Ausnehmung 3 befindet sich das erste Kontaktelement 5 in elektrischem und direktem Kontakt mit dem Grundkörper 2. Die Ausnehmung 3 weist dabei eine Seitenfläche 3a und eine Bodenfläche 3b auf, die jeweils vollständig vom ersten Kontaktelement 5 bedeckt sind. Durch die Tiefe der Ausnehmung 3 kann bei gleich bleibender Dicke d des Grundkörpers 2 der Abstand zwischen erstem Kontaktelement 5 und zweitem Kontaktelement 6 an der zweiten Hauptfläche 2b des Grundkörpers 2 eingestellt werden. Das heißt, über die Tiefe der Ausnehmung kann die Kurzstromstrecke h eingestellt werden und damit der Widerstandswert des elektrischen Widerstandselements. Ferner kann der Widerstand über den Durchmesser der Ausnehmung D eingestellt werden. Je größer der Durchmesser D, desto mehr Strom kann durch dreidimensionalen Stromtransport durch den Grundkörper 2 hindurch fließen.

Die Dotierstoffkonzentration des Grundkörpers, der beispielsweise aus Silizium besteht, kann aufgrund der Ausnehmung im Bereich von höchstens 10¹⁷/cm³ gewählt werden, wobei die Dicke des Grundkörpers 2 wenigstens 100 µm groß gewählt werden kann, was eine ausreichende mechanische Stabilität des Widerstandselements 1 sicherstellt. Bei einem Temperaturanstieg zwischen 25° C und 150°C kann ein Faktor des Widerstandsanstiegs von > 2 erreicht werden, wobei Widerstandswerte zwischen wenigstens 3 und höchstens 10 Ω über die Tiefe der Ausnehmung, das heißt die Länge der Kurzschlussstrecke h einstellbar sind. Die lateralen Abmessungen L des Widerstandselements 1 werden beispielsweise so gewählt, dass dessen Grundfläche höchstens 1 mm² beträgt.

In Verbindung mit der schematischen Schnittdarstellung der Figur 3 ist ein weiteres Ausführungsbeispiel eines hier beschriebenen Widerstandselements 1 näher erläutert. In diesem Ausführungsbeispiel ist die Ausnehmung 3 pyramidenförmig ausgebildet. Bei der ersten Hauptfläche 2a des Grundkörpers 2 handelt es sich beispielsweise um eine Silizium (100)-Oberfläche. Die Ausnehmung 3 ist mittels eines anisotropen Ätzens, zum Beispiel mit einem nasschemischen Ätzen mittels KOH erzeugt. Dadurch entsteht eine pyramidenartige Ausnehmung, die einen halben Öffnungswinkel α von zirka 35,3° aufweist, der durch die Siliziumkristallstruktur vorgegeben ist. Der Ätzvorgang endet ohne äußeres Zutun, sobald sich die Pyramide ausgebildet hat, aufgrund des anisotropen Ätzens. Die Länge h des Kurzschlusspfades zwischen dem ersten Kontaktelement 5, das in die Ausnehmung 3 eingebracht ist, und dem zweiten Kontaktelement 6 ist durch den Abstand der Spitze der Pyramide zur zweiten Hauptfläche 2b des Grundkörpers 2 bestimmt. Durch den maximalen Durchmesser D der zum Beispiel kreisförmigen Öffnung im Passivierungselement 4, das vorliegend auch als Ätzmaske dient, kann die Länge h des Kurzschlusspfades bei vorgegebener Dicke d des Grundkörpers 2 auf einfache Weise eingestellt werden. Es ist also eine besonders einfache Herstellung des Widerstandselements 1 möglich. Als einzige Schwierigkeit ergibt sich, das aufgrund der komplexen Geometrie der Ausnehmung und damit der Kontaktfläche zwischen erstem Kontaktelement 5 und Grundkörper 2 Computersimulationen oder Versuche notwendig sind zur Bestimmung des maximalen Durchmessers D der Ausnehmung 3, um einen vorgegebenen Widerstandswert einzustellen.

Anhand der schematischen Draufsicht der Figur 4 ist ein hier beschriebenes Verfahren zur Herstellung einer Vielzahl von Widerstandselemente 1 näher erläutert. Die Figur 4 zeigt in der Draufsicht einen kleinen Ausschnitt aus einem Wafer 20. Die Figur 4 zeigt dabei vier Widerstandselemente 1, bei denen im Passivierungselement 4 Öffnungen mit unterschiedlichem Durchmesser D gebildet sind. Aufgrund der unterschiedlich großen Öffnungen im als Ätzmaske dienenden Passivierungselement 4 werden Ausnehmungen 3 mit unterschiedlichem maximalen Durchmesser D und unterschiedlicher Tiefe durch den oben beschriebenen Ätzprozess erzeugt. Mit anderen Worten können auf einem einzigen Wafer mehrere Widerstandselemente 1 erzeugt werden, die sich hinsichtlich ihrer Ausnehmungen 3 und damit hinsichtlich ihres Widerstandswerts voneinander unterscheiden. Die Dicke des Wafers und die Dotierstoffkonzentration ist dabei für alle Widerstandselemente gleich.

In Verbindung mit der schematischen Schaltskizze der Figur 5A ist ein erstes Ausführungsbeispiel einer hier beschriebenen Beleuchtungsvorrichtung näher erläutert. Die Beleuchtungsvorrichtung umfasst eine erste Anordnung 7 von Leuchtdioden, die zumindest eine Leuchtdiode 7a erster Art umfasst. Bei der Leuchtdiode 7a handelt es sich beispielsweise um einen rotes Licht emittierenden Leuchtdiodenchip. Der rotes Licht emittierende Leuchtdiodenchip weist eine relativ starke Temperaturabhängigkeit der Intensität des von ihm abgestrahlten Lichts auf. So fällt die Intensität des abgestrahlten Lichts mit steigender Temperatur stark ab.

Die Beleuchtungsvorrichtung weist ferner eine zweite Anordnung 8 von Leuchtdioden auf, die zumindest eine Leuchtdiode 8b zweiter Art umfasst. Bei der Leuchtdiode 8b handelt es sich beispielsweise um eine blaues Licht emittierende Leuchtdiode, die eine geringere Temperaturempfindlichkeit als die Leuchtdiode erster Art 7a aufweist. Der Leuchtdiode 8b kann dabei ein Leuchtstoff nachgeordnet sein, so dass die Leuchtdiode weißes, grünes oder gelbes Licht emittiert. Das heißt, die Intensität des von der Leuchtdiode zweiter Art 8a abgestrahlten Lichts nimmt mit steigender Temperatur weniger stark ab als bei der Leuchtdiode 7a erster Art. Ein hier beschriebenes Widerstandselement 1, wie es beispielsweise in Verbindung mit den Figuren 2 und 3 beschrieben ist, ist mit der zweiten Anordnung 8 von Leuchtdioden zu einer Serienschaltung 10 verschaltet. Die Serienschaltung 10 ist der ersten Anordnung von Leuchtdioden parallel geschaltet. Die Beleuchtungseinrichtung weist ferner erste und zweite Kontaktstellen 9a, 9b auf.

Das Widerstandselement 1 sorgt nun aufgrund seines positiven Temperaturkoeffizienten dafür, dass der Intensitätsabfall der Leuchtdioden 7a erster Art mit steigender Temperatur ausgeglichen wird, indem mit steigender Temperatur mehr Leistung am Widerstandselement 1a verbraucht wird und damit weniger Licht von der zweiten Anordnung 8 von Leuchtdioden zweiter Art erzeugt wird. Das heißt, aufgrund der Parallelschaltung ist die Spannung bei der zweiten Anordnung 8 von Leuchtdioden größer und es fließt weniger Strom durch die zweite Anordnung 8, während die erste Anordnung 7 von einem höheren Strom durchflossen wird. Auf diese Weise kann Mischlicht von der Beleuchtungsvorrichtung erzeugt werden, das einen besonders konstanten Farbort aufweist.

Anhand der Figur 5b ist beispielhaft gezeigt, dass die Beleuchtungsvorrichtung um weitere Anordnungen 18 von Leuchtdioden ergänzt werden kann. Beispielsweise umfasst die weitere Anordnung von Leuchtdioden 18 Leuchtdioden zweiter, erster und/oder einer weiteren Art.

Bei den hier beschriebenen Beleuchtungsvorrichtungen ist es möglich, dass die Leuchtdioden vorliegend als Leuchtdiodenchips sowie das Widerstandselement in einem gemeinsamen Gehäuse angeordnet sind, so dass sich ein besonders kompakter Aufbau der Beleuchtungsvorrichtung ergibt.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

Diese Patentanmeldung beansprucht die Priorität der deutschen Patentanmeldung 102010008603. 7.

## Patentansprüche

1. Elektrisches Widerstandselement (1) mit
- einem Grundkörper (2), der mit einem Halbleitermaterial gebildet ist,
- einem ersten Kontaktelement (5), das mit dem Grundkörper (2) elektrisch leitend verbunden ist, und
- einem zweiten Kontaktelement (6), das mit dem Grundkörper (2) elektrisch leitend verbunden ist, wobei
- der Grundkörper (2) eine erste Hauptfläche (2a) aufweist, in die eine Ausnehmung (3) eingebracht ist,
- das erste Kontaktelement (5) in der Ausnehmung (3) zumindest stellenweise elektrisch leitend mit dem Grundkörper (2) verbunden ist,
- der Grundkörper (2) eine zweite Hauptfläche (2b) aufweist, die der ersten Hauptfläche (2a) gegenüberliegend angeordnet ist,
- das zweite Kontaktelement (6) an der zweiten Hauptfläche (2b) zumindest stellenweise elektrisch leitend mit dem Grundkörper (2) verbunden ist.

2. Elektrisches Widerstandselement (1) nach dem vorherigen Anspruch,
bei dem zwischen der ersten Hauptfläche (2a) und dem ersten Kontaktelement (5) ein elektrisch isolierendes Passivierungselement (4) angeordnet ist.

3. Elektrisches Widerstandselement (1) nach einem der vorherigen Ansprüche,
bei dem das erste Kontaktelement (5) und der Grundkörper lediglich im Bereich der Ausnehmung (3) elektrisch leitend miteinander verbunden sind.

4. Elektrisches Widerstandselement (1) nach einem der vorherigen Ansprüche,
bei dem die Ausnehmung zumindest eine Seitenfläche (3a) und zumindest eine Bodenfläche (3b) aufweist, wobei
- die zumindest eine Seitenfläche (3a) und die zumindest eine Bodenfläche (3b) die Ausnehmung zum Grundkörper (2) hin begrenzen, und
- die zumindest eine Seitenfläche (3a) und die zumindest eine Bodenfläche (3b) vollständig in direktem Kontakt mit dem ersten Kontaktelement (5) stehen.

5. Elektrisches Widerstandselement (1) nach einem der vorherigen Ansprüche,
bei dem die Ausnehmung nach Art einer Pyramide ausgebildet ist, deren Spitze der zweiten Hauptfläche (2b) zugewandt ist.

6. Elektrisches Widerstandselement (1) nach einem der vorherigen Ansprüche,
bei dem die Ausnehmung an ihrer zumindest einen Seitenfläche (3a) und ihrer zumindest einen Bodenfläche (3b) Spuren eines Ätzprozesses aufweist.

7. Elektrisches Widerstandselement (1) nach einem der vorherigen Ansprüche mit
- einem positiven Temperaturkoeffizient.

8. Elektrisches Widerstandselement (1) nach einem der vorherigen Ansprüche,
bei dem der Grundkörper (2) aus einem dotierten Silizium besteht, wobei die Dotierstoffkonzentration wenigstens 10¹⁵ cm⁻³ und höchstens 10¹⁷ cm⁻³ beträgt.

9. Elektrisches Widerstandselement (1) nach einem der vorherigen Ansprüche,
bei dem der Grundkörper (2) eine Dicke von wenigsten 100 µm aufweist.

10. Elektrisches Widerstandselement (1) nach einem der vorherigen Ansprüche,
bei dem die erste Hauptfläche (2a) und/oder die zweite Hauptfläche (2b) eine Grundfläche von höchstens 1 mm² aufweisen.

11. Verfahren zur Herstellung einer Vielzahl elektrischer Widerstandselemente (1) nach einem der vorherigen Ansprüche mit den folgenden Schritten:
- Bereitstellen eines Wafers (20) aus einem Halbleitermaterial
- Aufbringen eines Passivierungselements (4) auf eine erste Hauptfläche (20a) des Wafers (20),
- stellenweise Bildung von Öffnungen im Passivierungselement (4) in denen jeweils das Halbleitermaterial freiliegt,
- Durchführen eines nasschemischen Ätzverfahrens auf das in den Öffnungen freiliegende Halbleitermaterial zur Bildung von Ausnehmungen (3), und
- Einbringen von ersten Kontaktelementen (5) in zumindest manche der Ausnehmungen.

12. Verfahren nach dem vorherigen Anspruch,
wobei zumindest zwei der Ausnehmungen einen voneinander unterschiedlichen maximalen Durchmesser (D) aufweisen.

13. Beleuchtungsvorrichtung mit
- einer ersten Anordnung (7) von Leuchtdioden, die zumindest eine Leuchtdiode (7a) erster Art umfasst,
- einer zweiten Anordnung (8) von Leuchtdioden, die zumindest eine Leuchtdiode (8a) zweiter Art umfasst, und
- einem Widerstandelement (1) nach einem der Ansprüche 1 bis 10, wobei
- die Leuchtdioden (8a) erster Art eine anderer Temperaturabhängigkeit als die Leuchtdioden (8b) zweiter Art aufweisen,
- das Widerstandselement (1) und die zweite Anordnung (8) von Leuchtdioden eine Serienschaltung (10) bilden, und
- die Serienschaltung (10) und die ersten Anordnung von Leuchtdioden (7) eine Parallelschaltung bilden.

## Claims

1. Electric resistance element (1) comprising
- a base body (2), which is formed with a semiconductor material,
- a first contact element (5), which is electrically conductively connected to the base body (2), and
- a second contact element (6), which is electrically conductively connected to the base body (2), wherein
- the base body (2) has a first main surface (2a) into which a cutout (3) is introduced,
- the first contact element (5) is electrically conductively connected to the base body (2) at least in places in the cutout (3),
- the base body (2) has a second main surface (2b), which is arranged in a manner lying opposite the first main surface (2a),
- the second contact element (6) is electrically conductively connected to the base body (2) at least in places at the second main surface (2b).

2. Electric resistance element (1) according to the preceding claim,
wherein an electrically insulating passivation element (4) is arranged between the first main surface (2a) and the first contact element (5).

3. Electric resistance element (1) according to either of the preceding claims,
wherein the first contact element (5) and the base body are electrically conductively connected to one another only in the region of the cutout (3).

4. Electric resistance element (1) according to any of the preceding claims,
wherein the cutout has at least one side surface (3a) and at least one bottom surface (3b), wherein
- the at least one side surface (3a) and the at least one bottom surface (3b) delimit the cutout toward the base body (2), and
- the at least one side surface (3a) and the at least one bottom surface (3b) are completely in direct contact with the first contact element (5).

5. Electric resistance element (1) according to any of the preceding claims,
wherein the cutout is embodied in the manner of a pyramid whose vertex faces the second main surface (2b) .

6. Electric resistance element (1) according to any of the preceding claims,
wherein the cutout has traces of an etching process at its at least one side surface (3a) and its at least one bottom surface (3b).

7. Electric resistance element (1) according to any of the preceding claims having
- a positive temperature coefficient.

8. Electric resistance element (1) according to any of the preceding claims,
wherein the base body (2) consists of a doped silicon, wherein the dopant concentration is at least 10¹⁵ cm⁻³ and at most 10¹⁷ cm⁻³.

9. Electric resistance element (1) according to any of the preceding claims,
wherein the base body (2) has a thickness of at least 100 µm.

10. Electric resistance element (1) according to any of the preceding claims,
wherein the first main surface (2a) and/or the second main surface (2b) have/has a basic area of at most 1 mm².

11. Method for producing a multiplicity of electric resistance elements (1) according to any of the preceding claims, comprising the following steps:
- providing a wafer (20) composed of a semiconductor material,
- applying a passivation element (4) to a first main surface (20a) of the wafer (20),
- forming openings in places in the passivation element (4), the semiconductor material in each case being uncovered in said openings,
- carrying out a wet-chemical etching method onto the semiconductor material uncovered in the openings in order to form cutouts (3), and
- introducing first contact elements (5) into at least some of the cutouts.

12. Method according to the preceding claim,
wherein at least two of the cutouts have a mutually different maximum diameter (D).

13. Illumination device comprising
- a first arrangement (7) of light-emitting diodes, which comprises at least one light-emitting diode (7a) of a first type,
- a second arrangement (8) of light-emitting diodes, which comprises at least one light-emitting diode (8a) of a second type,
- a resistance element (1) according to any of Claims 1 to 10, wherein
- the light-emitting diodes (8a) of a first type have a different temperature dependence than the light-emitting diodes (8b) of a second type,
- the resistance element (1) and the second arrangement (8) of light-emitting diodes form a series circuit (10), and
- the series circuit (10) and the first arrangement of light-emitting diodes (7) form a parallel circuit.

## Revendications

1. Elément (1) de résistance électrique présentant
un corps de base (2) formé d'un matériau semi-conducteur,
un premier élément de contact (5) raccordé de manière électriquement conductrice au corps de base (2) et
un deuxième élément de contact (6) raccordé de manière électriquement conductrice au corps de base (2),
le corps de base (2) présentant une première surface principale (2a) dans laquelle est ménagée une découpe (3),
le premier élément de contact (5) étant raccordé au corps de base (2) dans la découpe (3) de manière électriquement conductrice au moins par endroits,
le corps de base (2) présentant une deuxième surface principale (2b) disposée face à la première surface principale (2a) et
le deuxième élément de contact (6) étant raccordé de manière électriquement conductrice au moins par endroits au corps de base (2) sur la deuxième surface principale (2b) .

2. Elément (1) de résistance électrique selon la revendication précédente, dans lequel un élément de passivation (4) électriquement isolant est disposé entre la première surface principale (2a) et le premier élément de contact (5).

3. Elément (1) de résistance électrique selon l'une des revendications précédentes, dans lequel le premier élément de contact (5) et le corps de base sont raccordés l'un à l'autre de manière électriquement conductrice uniquement au niveau de la découpe (3).

4. Elément (1) de résistance électrique selon l'une des revendications précédentes, dans lequel la découpe présente au moins une surface latérale (3a) et au moins une surface de fond (3b), la ou les surfaces latérales (3a) et la ou les surfaces de fond (3b) délimitant la découpe par rapport au corps de base (2) et la ou les surfaces latérales (3a) et la ou les surfaces de fond (3b) étant complètement en contact direct avec le premier élément de contact (5).

5. Elément (1) de résistance électrique selon l'une des revendications précédentes, dans lequel la découpe est configurée en pyramide dont la pointe est tournée vers la deuxième surface principale (2b).

6. Elément (1) de résistance électrique selon l'une des revendications précédentes, dans lequel la découpe présente sur sa ou ses surfaces latérales (3a) et sur sa ou ses surfaces de fond (3b) des traces d'une opération de gravure.

7. Elément (1) de résistance électrique selon l'une des revendications précédentes, présentant un coefficient de température positif.

8. Elément (1) de résistance électrique selon l'une des revendications précédentes, dans lequel le corps de base (2) est constitué d'un silicium dopé dont la concentration en élément de dopage est comprise entre au moins 10¹⁵ cm⁻³ et au plus 10¹⁷ cm⁻³.

9. Elément (1) de résistance électrique selon l'une des revendications précédentes, dans lequel le corps de base (2) présente une épaisseur d'au moins 100 µm.

10. Elément (1) de résistance électrique selon l'une des revendications précédentes, dans lequel la première surface principale (2a) et/ou la deuxième surface principale (2b) présentent une surface de base d'au plus 1 mm².

11. Procédé de fabrication de plusieurs éléments (1) de résistance électrique selon l'une des revendications précédentes, le procédé présentant les étapes suivantes :
préparation d'une galette (20) en un matériau semi-conducteur,
application d'un élément de passivation (4) sur une première surface principale (20a) de la galette (20),
formation par endroits d'ouvertures dans l'élément de passivation (4), dans chacune desquelles le matériau semi-conducteur est exposé,
exécution d'une opération de gravure chimique en conditions humides sur le matériau semi-conducteur libéré dans les ouvertures, en vue de former des découpes (3) et
placement de premiers éléments de contact (5) dans au moins certaines des découpes.

12. Procédé selon la revendication précédente, dans lequel le diamètre maximum (D) d'au moins deux des découpes sont différents l'un de l'autre.

13. Dispositif d'éclairage présentant
un premier ensemble (7) de diodes luminescentes qui comporte au moins une diode luminescente (7a) d'un premier type,
un deuxième agencement (8) de diodes luminescentes qui comporte au moins une diode luminescente (8a) d'un deuxième type et
un élément de résistance (1) selon l'une des revendications 1 à 10,
les diodes luminescentes (8a) du premier type présentant une autre dépendance vis-à-vis de la température que les diodes luminescentes (8b) du deuxième type,
l'élément de résistance (1) et le deuxième agencement (8) de diodes luminescentes formant un circuit série (10) et
le circuit série (10) et le premier agencement de diodes luminescentes (7) formant un circuit parallèle.
